## Europäisches Patentamt

## European Patent Office

## Office européen des brevets

(19)

(11) **EP 0 948 775 B1**

(12)

# FASCICULE DE BREVET EUROPEEN

(45) Date de publication et mention
de la délivrance du brevet:
**30.05.2001 Bulletin 2001/22**

(51) Int Cl.⁷: **G06K 7/00**, G06K 19/07

(21) Numéro de dépôt: **97930581.0**

(86) Numéro de dépôt international:
**PCT/FR97/01128**

(22) Date de dépôt: **25.06.1997**

(87) Numéro de publication internationale:
**WO 98/06056 (12.02.1998 Gazette 1998/06)**

(54) **CIRCUIT INTEGRE A FONCTIONNEMENT SANS CONTACT, COMPORTANT UNE POMPE DE CHARGES**

KONTAKTLOSE INTEGRIERTE SCHALTUNG MIT EINER LADUNGSPUMPE

NON-CONTACT INTEGRATED CIRCUIT COMPRISING A CHARGE PUMP

(84) Etats contractants désignés:
**AT BE CH DE ES FR GB IT LI NL**

(30) Priorité: **06.08.1996 FR 9609909**

(43) Date de publication de la demande:
**13.10.1999 Bulletin 1999/41**

(73) Titulaire: **Inside technologies
69930 Saint-Clément-les-Places (FR)**

(72) Inventeurs:
 • **KOWALSKI, Jacek
  F-13090 Aix en Provence (FR)**

 • **MARTIN, Michel
  F-13840 Rognes (FR)**

(74) Mandataire: **Marchand, André
  OMNIPAT,
  24 Place des Martyrs de la Résistance
  13100 Aix-en-Provence (FR)**

(56) Documents cités:
  **US-A- 5 206 495**          **US-A- 5 285 370**

## Description

La présente invention concerne un circuit intégré pouvant fonctionner sans contact au moyen d'au moins une bobine formant avec une capacité d'accord un circuit résonant accordé, et comprenant une pompe de charges à deux entrées d'horloge.

Les circuits intégrés utilisés pour réaliser des cartes à puce, des étiquettes électroniques et de façon générale les circuits intégrés montés sur des supports portables, comprennent pour la plupart une mémoire EEPROM (mémoire programmable et effaçable électriquement) pour enregistrer et stocker des données, ainsi qu'un circuit survolteur pour délivrer une haute tension de programmation ou d'effacement de cette mémoire. En effet, une tension de programmation ou d'effacement d'une mémoire EEPROM est typiquement de l'ordre de 15 à 20 V alors que la tension d'alimentation Vcc d'un circuit intégré n'est que de l'ordre de 3 à 5 V.

Dans le domaine de la microélectronique, le mode de réalisation préféré d'un circuit survolteur est la pompe de charges, qui se prête bien à une intégration sur silicium.

Le problème que pose toutefois une pompe de charges est de devoir être pilotée par des signaux d'horloge. De tels signaux doivent être fournis par un oscillateur qui présente généralement une certaine consommation de courant. Dans le cas d'un circuit intégré sans contact alimenté par induction électromagnétique et disposant de faibles ressources énergétiques, une telle consommation de courant peut n'être pas souhaitable.

Avant d'aborder plus en détail ce problème technique, on rappellera tout d'abord la structure classique d'une pompe de charges et l'agencement classique d'une telle pompe de charges dans un circuit intégré sans contact.

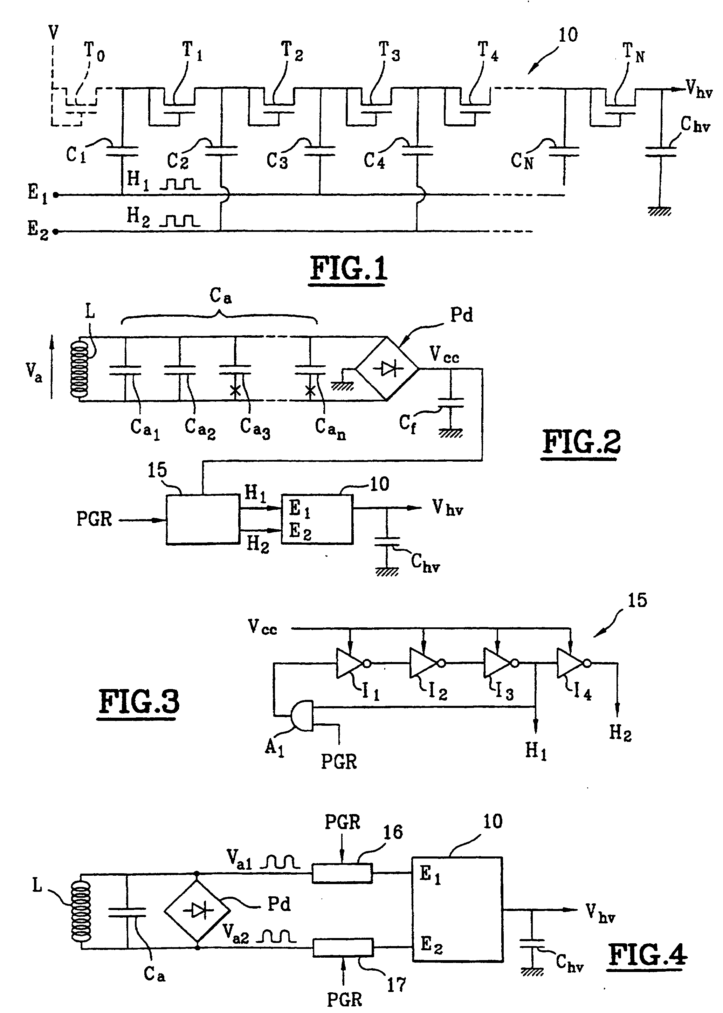

La pompe de charges représentée sur la figure 1 comprend une pluralité de capacités en cascade, par exemple N capacités $C_1$ à $C_N$. L'anode de chaque capacité $C_1$, $C_2$,... est reliée à l'anode de la capacité suivante $C_2$, $C_3$,... par l'intermédiaire de transistors MOS $T_1$ à $T_N$ ayant leurs grilles ramenées sur leurs drains et assimilables à des diodes. En bout de chaîne, le transistor $T_N$ relie l'anode de la capacité $C_N$ à l'anode d'une capacité de stockage $C_{hv}$ dont la cathode est à la masse. Les cathodes des capacités de rang impair $C_1$, $C_3$,... sont attaquées par un signal d'horloge $H_1$ appliqué sur une entrée $E_1$ de la pompe de charges et les cathodes des capacités de rang pair $C_2$, $C_4$,... par un signal $H_2$ appliqué sur une entrée $E_2$, le signal H2 étant en opposition de phase avec le signal $H_1$. Ainsi, alternativement, chaque capacité de rang impair $C_1$, $C_3$,... se décharge dans la capacité suivante de rang pair $C_2$, $C_4$..., et chaque capacité de rang pair $C_2$, $C_4$,... se décharge dans la capacité suivante de rang impair $C_3$, $C_5$, ... En bout de chaîne, la capacité $C_N$ se décharge dans la capacité $C_{hv}$ aux bornes de laquelle on trouve une haute tension $V_{hv}$.

La figure 2 représente un agencement classique de la pompe de charges 10 au sein d'un circuit intégré sans contact 20. Le circuit intégré 20 comprend une bobine L formant avec une capacité d'accord Ca un circuit résonant accordé LCa permettant au circuit intégré de recevoir par induction électromagnétique une tension alternative Va. La pompe de charges 10 est connectée par ses entrées d'horloge $E_1$ et $E_2$ à un oscillateur 15 commandé par un signal PGR et délivrant les signaux d'horloge $H_1$ et $H_2$. L'oscillateur 15 reçoit une tension d'alimentation Vcc d'un pont redresseur Pd à diodes ou à transistors recevant en entrée la tension induite alternative Va et comportant à sa sortie une capacité de filtrage Cf. Un exemple classique de réalisation de l'oscillateur 15 est représenté en figure 3. Trois portes inverseuses en cascade $I_1$, $I_2$; $I_3$ sont agencées en boucle fermée par l'intermédiaire d'une porte ET référencée A1 commandée par le signal PGR. Le signal $H_1$ est par exemple prélevé à la sortie de la dernière porte $I_3$ et le signal inverse $H_2$ délivré par une quatrième porte inverseuse $I_4$.

La capacité d'accord Ca est généralement une capacité ajustable, ajustée de manière que la fréquence de résonance du circuit LCa soit aussi proche que possible de la fréquence d'oscillation du champ magnétique dans lequel le circuit intégré 20 est destiné à fonctionner. Comme représenté, la capacité d'accord Ca comprend par exemple plusieurs capacités $Ca_1$ à $Ca_n$ en parallèle, les pistes métalliques assurant la connexion de certaines capacités ayant été sectionnées au moment de l'ajustage.

Ainsi, lorsqu'une opération d'écriture ou d'effacement d'une mémoire EEPROM (non représentée) doit être réalisée, le signal PGR est mis à 1, la porte A1 devient transparente, l'oscillateur 15 démarre et la pompe de charges 10 est activée.

Comme évoqué plus haut, le fonctionnement de l'oscillateur 15 entraîne une consommation de courant non négligeable du fait de la commutation rapide des diverses portes inverseuses. Au démarrage d'une opération de programmation ou d'effacement, quand le signal PGR est mis à 1, cette consommation s'ajoute à celle de la pompe de charges 10 qui doit assurer la charge de la capacité de stockage Chv. De plus, dans une carte à puce sans contact ou une étiquette électronique, une telle opération de programmation ou d'effacement peut être déclenchée à un instant où les conditions de réception de la tension induite Va sont mauvaises. Ainsi, si l'énergie reçue par la bobine L est trop faible, la tension d'alimentation Vcc peut s'affaisser en provoquant l'arrêt du fonctionnement du circuit intégré.

Il est donc souhaitable, dans un circuit intégré sans contact, de limiter autant que possible la consommation de courant pendant les périodes de génération de la haute tension Vhv.

Dans l'état de la technique, on connaît également une méthode consistant à activer directement une pompe de charges au moyen des alternances positives et négatives d'une tension alternative induite dans une bobine.

Cette méthode, illustrée par la figure 4, consiste à connecter les deux bornes de la bobine L aux deux entrées $E_1$ et $E_2$ de la pompe de charges par l'intermédiaire de deux interrupteurs 16, 17 commandés par le signal de programmation PGR. Quand le signal PGR est à 1, les interrupteurs 16, 17 sont fermés et les alternances Va1 et Va2 envoyées directement dans la pompe de charges 10 en tant que signaux d'activation $H_1$ et $H_2$.

Toutefois, la demanderesse a constaté que cette méthode, bien que permettant la suppression de l'oscillateur 15, présente l'inconvénient de désaccorder le circuit résonant LCa.

En effet, si l'on se reporte au schéma de la figure 1, une pompe de charges vue de ses entrées $E_1$ et $E_2$ est l'équivalent d'une capacité $C_E$ de valeur

$$(2) \qquad C_E = N \ C/2$$

N étant le nombre d'étages de la pompe de charges et C la valeur des capacités $C_1$, $C_2$, ... $C_N$ de chaque étage.

En conséquence, sur la figure 4, lorsque le signal PGR passe à 1 et que la pompe de charges 10 se trouve connectée à la bobine L, la capacité $C_E$ désaccorde sensiblement le circuit résonant LCa et la réception de l'énergie se fait dans de mauvaises conditions.

La présente invention vise à pallier cet inconvénient.

Le brevet US 5,206,495 décrit une carte à puce à deux modes de fonctionnement, avec ou sans contact, comprenant un circuit intégré, des plages de contact pour fonctionner en mode contact et deux bobines pour fonctionner en mode sans contact.

Le brevet US 5,285,370 décrit un dispositif dans lequel la tension induite aux bornes d'une bobine est utilisée pour activer les entrées d'horloge d'une pompe de charges. Toutefois, le dispositif est équipé d'une bobine d'induction "large bande" dépourvue de capacité d'accord et ne formant pas un circuit résonnant. Ce document recommande par ailleurs d'interposer un interrupteur entre la bobine et les entrées d'horloge de la pompe de charge de manière que la bobine ne soit connectée à cette dernière que lorsque cela est nécessaire.

Ainsi, la présente invention a pour objectif de permettre l'activation directe d'une pompe de charges au moyen de la bobine d'un circuit résonant, sans toutefois désaccorder le circuit résonant.

Pour atteindre cet objectif, la présente invention repose sur l'idée simple mais non moins inventive de connecter en permanence la pompe de charges à la bobine, de manière que la capacité d'entrée $C_E$ de la pompe de charges fasse partie intégrante de la capacité d'accord Ca du circuit résonant.

La mise en oeuvre de l'invention implique que le circuit résonant soit accordé en tenant compte de la capacité d'entrée de la pompe de charges.

Plus particulièrement, la présente invention prévoit un circuit intégré pouvant fonctionner sans contact au moyen d'au moins une bobine formant avec une capacité d'accord un circuit résonant accordé, comprenant une pompe de charges à deux entrées d'horloge, dans lequel, au moins pendant des périodes de fonctionnement sans contact du circuit intégré, les entrées d'horloge de la pompe de charges sont connectées en permanence aux bornes de la bobine, la capacité de la pompe de charges vue de ses entrées d'horloge constituant une composante permanente de la capacité d'accord du circuit résonant accordé.

Selon un mode de réalisation, les entrées d'horloge de la pompe de charges sont directement connectées aux bornes de la bobine.

Selon un mode de réalisation, les entrées d'horloge de la pompe de charges sont connectées aux bornes de la bobine par l'intermédiaire de premiers interrupteurs commandés à la fermeture au moins pendant des périodes de fonctionnement sans contact du circuit intégré.

Par exemple, quand le circuit intégré présente deux modes de fonctionnement, avec ou sans contact, les premiers interrupteurs sont commandés par un signal représentatif du mode de fonctionnement du circuit intégré.

Dans ce cas, selon un mode de réalisation, les entrées d'horloge de la pompe de charges sont en outre connectées aux sorties d'un oscillateur par l'intermédiaire de seconds interrupteurs.

La présente invention concerne également un support portable comprenant circuit intégré selon l'invention, notamment une carte à puce.

Ces caractéristiques et avantages ainsi que d'autres de la présente invention seront exposés plus en détails dans la description suivante d'un circuit intégré à fonctionnement sans contact et d'un circuit intégré à fonctionnement mixte avec ou sans contact selon l'invention, en relation avec les figures jointes parmi lesquelles :

- la figure 1 précédemment décrite est le schéma électrique d'une pompe de charge,
- la figure 2 précédemment décrite illustre un agencement classique d'une pompe de charges dans un circuit intégré fonctionnant sans contact,
- la figure 3 précédemment décrite est le schéma électrique d'un oscillateur,
- la figure 4 précédemment décrite illustre un autre agencement classique d'une pompe de charges dans un circuit intégré fonctionnant sans contact,
- la figure 5 représente un agencement selon l'invention d'une pompe de charges dans un circuit intégré fonctionnant sans contact,
- la figure 6 représente le circuit équivalent d'un circuit résonant accordé présent dans le circuit intégré de la figure 5,

- la figure 7 représente un agencement selon l'invention d'une pompe de charges dans un circuit intégré à fonctionnement mixte, avec ou sans contact.

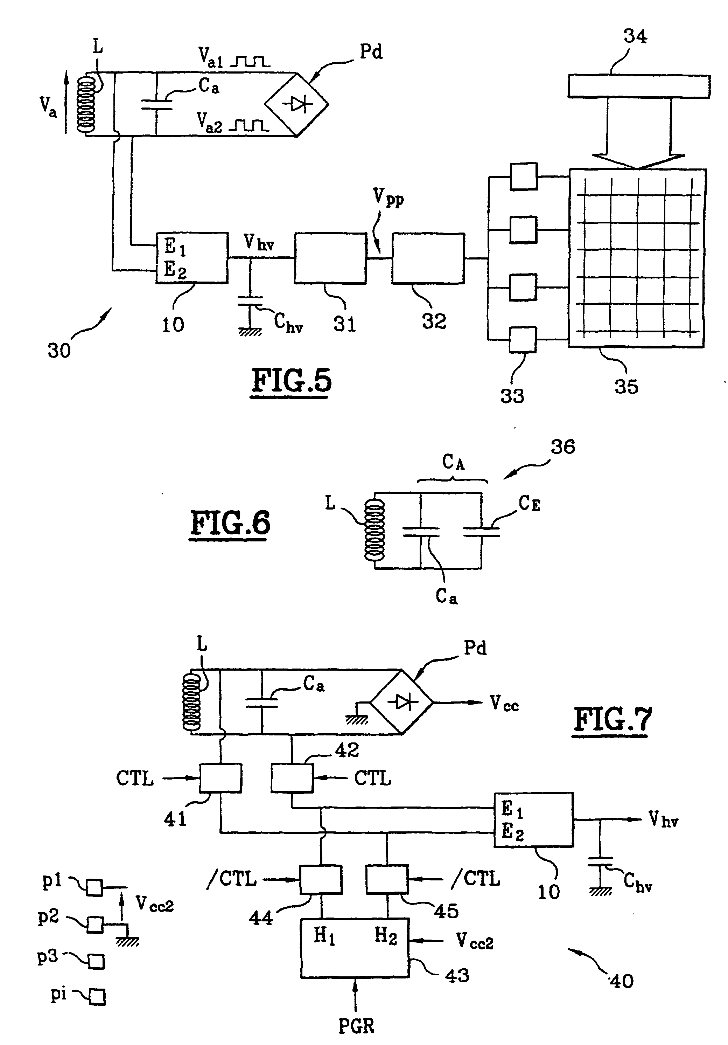

La figure 5 représente un agencement selon l'invention, dans un circuit intégré 30 fonctionnant sans contact, de la pompe de charges 10 déjà décrite au préambule. On retrouve dans le circuit 30 la bobine L, la capacité ajustée Ca et le pont redresseur Pd déjà décrits. Selon l'invention, les entrées d'activation $E_1$ et $E_2$ de la pompe de charges 10 sont directement connectées aux deux bornes de la bobine L et reçoivent en permanence les alternances Va1, Va2 de la tension alternative Va, lorsque celle-ci est présente. La pompe de charges 10 est alors active en permanence et la capacité Chv de stockage de la haute tension Vhv toujours chargée.

L'avantage de l'invention apparaît sur la figure 6 qui représente le schéma électrique équivalent du circuit résonant accordé 36 du circuit intégré 30. Le circuit résonant 36 comprend la bobine L, la capacité ajustée Ca et la capacité équivalente $C_E$ de la pompe de charges 10 vue de ses entrées $E_1$ et $E_2$. La capacité $C_E$ fait ainsi partie intégrante de la capacité d'accord $C_A$ du circuit résonant, qui n'est plus égale à la capacité ajustée Ca comme dans l'art antérieur mais égale à

$$(3) \qquad C_A = Ca + C_E$$

La présente invention permet ainsi la suppression de l'oscillateur de l'art antérieur sans les désavantages liés à une commutation temporaire de la pompe de charges.

Bien entendu, lors de la mise au point ou de la conception du circuit intégré selon l'invention, on tient compte de la valeur de la capacité $C_E$ de la pompe de charges.

Ainsi, la pompe de charges est activée en permanence au lieu de n'être activée que lorsque cela est nécessaire, par exemple pendant des périodes de programmation ou d'effacement d'une mémoire.

L'homme de l'art pourra constater que la méthode de l'invention n'apporte, en définitive, que des avantages. En particulier, le fait que la capacité haute tension Chv soit préchargée en permanence est un avantage dans la mesure où la haute tension Vhv est disponible à chaque instant sans la surconsommation classique due au démarrage de la pompe de charges. Cet avantage est particulièrement sensible quand le circuit intégré déclenche une opération de programmation ou d'effacement à un instant où il est éloigné de la source du champ magnétique (par exemple la bobine d'émission d'un lecteur de carte à puce sans contact), et que l'énergie reçue par la bobine L est très faible. Enfin, encore un autre avantage de la présente invention est que la capacité ajustée Ca peut être diminuée de la valeur $C_E$ et présente ainsi un moindre encombrement à la surface de silicium du circuit intégré.

Bien entendu, le fait que la capacité Chv soit préchargée en permanence ne signifie pas qu'une opération de programmation ou d'effacement d'une mémoire est réalisée en permanence. Pour fixer les idées, on a représenté schématiquement sur la figure 5 une chaîne d'éléments classiques permettant, à partir de la tension Vhv, de programmer une mémoire 35. La haute tension Vhv est tout d'abord appliquée à un circuit régulateur 31 qui délivre une haute tension régulée Vpp choisie en fonction des caractéristiques de la mémoire 35. Ensuite, la tension Vpp est envoyée dans un circuit de mise en forme 32, généralement un circuit générateur de rampe, qui permet d'appliquer progressivement la tension Vpp à la mémoire 35. Enfin la rampe de tension Vpp est appliquée à la mémoire 35 par l'intermédiaire d'interrupteurs haute tension 33 et de circuits 34 décodeurs d'adresses permettant de sélectionner les zones à programmer ou effacer. Pour que la mémoire 35 soit programmée ou effacée, il faut ainsi que l'ensemble de ces éléments soient activés.

La figure 7 illustre une application avantageuse de la présente invention à un circuit intégré 40 à deux modes de fonctionnement, avec ou sans contact. Outre les éléments déjà décrits, le circuit intégré 40 comprend divers plots de contact p1, p2,...pi, notamment un plot d'alimentation p1 pour recevoir une tension d'alimentation Vcc2 et un plot de masse p2. Les entrées $E_1$, $E_2$ de la pompe de charges 10 sont maintenant connectées aux bornes de la bobine L par l'intermédiaire de deux interrupteurs 41, 42 et aux sorties H1, H2 d'un oscillateur 43 par l'intermédiaire de deux autres interrupteurs 44, 45. Selon l'invention, les interrupteurs 41, 42 sont commandés par un signal CTL représentatif du mode de fonctionnement, avec ou sans contact, du circuit intégré. Les interrupteurs 44, 45 sont par exemple commandés par un signal inverse /CTL. Quand le circuit intégré 40 fonctionne dans le mode sans contact, le signal CTL est à 1 et le signal /CTL à 0. Les interrupteurs 41, 42 sont fermés, les interrupteurs 44, 45 sont ouverts et la pompe de charges 10 se trouve connectée en permanence aux bornes de la bobine L.

Inversement, quand le signal CTL est à 0 et le signal /CTL à 1, les interrupteurs 41, 42 sont ouverts et les interrupteurs 44, 45 fermés. Le circuit intégré 40 fonctionne comme un circuit intégré à contact classique. Notamment, l'oscillateur 43 peut être activé temporairement au moyen d'un signal PGR.

Le signal CTL permettant la discrimination du mode de fonctionnement du circuit intégré 40 peut être généré de diverses manières, par exemple au moyen d'une détection de la présence de la tension d'alimentation Vcc2 sur le plot p1, d'une détection de la présence de la tension Va sur la bobine L ou encore une détection de la présence de la tension Vcc à la sortie du pont redresseur Pd.

Il apparaîtra clairement à l'homme de l'art que la présente invention est susceptible de nombreuses variantes, modes de réalisation et perfectionnements.

Ainsi, selon une variante, la fermeture des interrupteurs 44, 45 en mode contact n'est pas déclenchée par le signal /CTL mais par un signal temporaire et spécifique aux opérations de programmation ou d'effacement, par exemple le signal PGR.

Selon une autre variante, l'oscillateur 43 est activé en permanence en mode contact de manière que la capacité Chv soit préchargée si le circuit intégré 40 bascule brutalement du mode contact au mode sans contact.

Par ailleurs, pour augmenter la puissance de la pompe de charges 10, celle-ci peut être alimentée par une tension V par l'intermédiaire d'un transistor-diode $T_0$, comme représenté en traits pointillés sur la figure 1. La tension V peut par exemple être la tension Vcc fournie par le pont redresseur Pd ou la tension Vcc2 fournie par le plot p1.

De plus, il est bien évident que, dans la présente demande et dans les revendications, le terme "pompe de charges" ne désigne pas uniquement le circuit représenté sur la figure 1 mais désigne de façon générale tout circuit survolteur qui, vu de ses entrées d'activation, peut être assimilé à une capacité.

Egalement, bien que le problème que résout la présente invention ait été présenté comme relatif aux circuits intégrés comportant une mémoire EEPROM, il est bien évident que la présente invention est susceptible de s'appliquer à tout circuit intégré comportant une pompe de charges, quelle que soit la fonction de la pompe de charges dans le circuit intégré.

Enfin, bien que l'on ait indiqué précédemment que l'accord du circuit résonant pouvait être obtenu par ajustage de la capacité Ca, il est bien évident que le circuit résonant peut être accordé au stade de la conception du circuit intégré si les tolérances de fabrication le permettent.

**Revendications**

1. Circuit intégré (30) comprenant une pompe de charges (10) à deux entrées d'horloge ($E_1$, $E_2$) et fonctionnant sans contact au moyen d'au moins une bobine (L) formant avec une capacité d'accord ($C_A$) un circuit résonant accordé (36), caractérisé en ce que, pendant les périodes de fonctionnement du circuit intégré :

   - les entrées d'horloge ($E_1$, $E_2$) de la pompe de charges (10) sont connectées en permanence aux bornes de la bobine (L), et
   - la capacité ($C_E$) de la pompe de charges vue de ses entrées d'horloge ($E_1$, $E_2$) constitue une composante permanente de la capacité d'accord ($C_A$) du circuit résonant accordé (36).

2. Circuit intégré (30) selon la revendication 1, dans lequel les entrées d'horloge ($E_1$, $E_2$) de la pompe de charges (10) sont directement connectées aux bornes de la bobine (L).

3. Circuit intégré (40) à deux modes de fonctionnement, avec ou sans contact, comprenant :

   - une pompe de charges (10) à deux entrées d'horloge ($E_1$, $E_2$),
   - au moins une bobine (L) formant avec une capacité d'accord ($C_A$) un circuit résonant accordé (36) pour recevoir une tension d'alimentation alternative (Va) dans le mode de fonctionnement sans contact, et
   - des plots de contact (p1, p2, pi) pour recevoir une tension d'alimentation continue (Vcc2) dans le mode de fonctionnement à contact,

   caractérisé en ce que :

   - les entrées d'horloge ($E_1$, $E_2$) de la pompe de charges (10) sont connectées aux bornes de la bobine (L) par l'intermédiaire de premiers interrupteurs (41, 42),
   - lesdits premiers interrupteurs (41, 42) sont commandés (CTL) en permanence à la fermeture pendant les périodes de fonctionnement sans contact du circuit intégré, de sorte que, pendant les périodes de fonctionnement sans contact du circuit intégré, les entrées d'horloge ($E_1$, $E_2$) de la pompe de charges (10) sont connectées en permanence aux bornes de la bobine (L),
   - la capacité ($C_E$) de la pompe de charges vue de ses entrées d'horloge ($E_1$, $E_2$) constitue une composante permanente de la capacité d'accord ($C_A$) du circuit résonant accordé (36).

4. Circuit intégré selon la revendication 4, dans lequel lesdits premiers interrupteurs (41, 42) sont commandés par un signal (CTL) représentatif du mode de fonctionnement du circuit intégré.

5. Circuit intégré selon l'une des revendications 3 et 4, dans lequel les entrées d'horloge ($E_1$, $E_2$) de la pompe de charges (10) sont en outre connectées aux sorties ($H_1$, $H_2$) d'un oscillateur (43) par l'intermédiaire de seconds interrupteurs (44, 45).

6. Circuit intégré selon la revendication 5, dans lequel lesdits seconds interrupteurs (44, 45) sont commandés à la fermeture pendant les périodes de fonctionnement avec contact du circuit intégré.

7. Circuit intégré selon l'une des revendications 5 et 6, dans lequel lesdits seconds interrupteurs (44, 45) sont commandés par l'intermédiaire d'un signal (/CTL) représentatif du mode de fonctionnement du circuit intégré.

8. Circuit intégré selon l'une des revendications précédentes, dans lequel la pompe de charges (10) comprend une pluralité de capacités ($C_1$-$C_N$) en cascade séparées par des diodes ($T_1$-$T_N$) et connectées à l'une ou l'autre des entrées d'horloge ($E_1$, $E_2$) de la pompe de charges.

9. Support portable comprenant un circuit intégré selon l'une des revendications précédentes.

10. Carte à puce comprenant un circuit intégré selon l'une des revendications 1 à 8.

**Patentansprüche**

1. Integrierte Schaltung (30) mit Ladungspumpen (10) mit zwei Takteingängen ($E_1$, $E_2$) und Funktion ohne Kontaktmittel mit Hilfe mindestens einer Spule (L), die mit einer Abstimmkapazität ($C_A$) eine abgestimmte Resonanzschaltung (36) bildet, dadurch gekennzeichnet, dass während den Funktionsperioden der integrierten Schaltung

   - die Takteingänge ($E_1$, $E_2$) der Ladungspumpen (10) permanent mit den Anschlussklemmen der Spule (L) verbunden sind, und

   - die Kapazität ($C_E$) der Ladungspumpen - betrachtet von deren Takteingängen ($E_1$, $E_2$) - einen permanenten Anteil der Abstimmkapazität ($C_A$) der abgestimmten Resonanzschaltung (36) bildet.

2. Integrierte Schaltung (30) nach Anspruch 1, dadurch gekennzeichnet, dass die Takteingänge ($E_1$, $E_2$) der Ladungspumpen (10) direkt mit den Anschlussklemmen der Spule (L) verbunden sind.

3. Integrierte Schaltung (40) mit zwei Funktionsmodi, mit oder ohne Kontakt, enthaltend:

   - eine Ladungspumpe (10) mit zwei Takteingängen ($E_1$, $E_2$),

   - mindestens eine Spule (L), die mit einer Abstimmkapazität ($C_A$) eine abgestimmte Resonanzschaltung (36) bildet, zum Empfangen einer Versorgungswechselspannung (Va) in dem Betriebsmodus ohne Kontakt, und

   - Kontaktstücke (p1, p2, pi) zum Empfangen einer Versorgungsgleichspannung (Vcc2) im Funktionsmodus mit Kontakt,

**dadurch gekennzeichnet, dass**

   - die Takteingänge ($E_1$, $E_2$) der Ladungspumpen (10) mit den Anschlussklemmen der Spule (L) über eine Zwischenschaltung der ersten Schalter (41, 42) verbunden sind,

   - die ersten Schalter (41, 42) permanent zum Schließen während der Funktionsperioden ohne Kontakt der integrierten Schaltung gesteuert sind (CTL), derart, dass während der Funktionsperioden ohne Kontakt der integrierten Schaltung die Takteingänge ($E_1$, $E_2$) der Ladungspumpen (10) permanent mit den Anschlussklemmen der Spule (L) verbunden sind,

   - die Kapazität ($C_E$) der Ladungspumpen - betrachtet von den Takteingängen ($E_1$, $E_2$) - einen permanenten Bestandteil der Abstimmkapazität ($C_A$) der abgestimmten Resonanzschaltung (36) bilden.

4. Integrierte Schaltung nach Anspruch 4, dadurch gekennzeichnet, dass die ersten Schalter (41, 42) durch ein Signal (CTL) zum Darstellen des Funktionsmodus der integrierten Schaltung gesteuert sind.

5. Integrierte Schaltung nach einem der Ansprüche 3 oder 4, dadurch gekennzeichnet, dass die Takteingänge ($E_1$, $E_2$) der Ladungspumpen (10) außerdem mit den Ausgängen ($H_1$, $H_2$) eines Oszillators (43) mittels zweiter Schalter (44, 45) verbunden sind.

6. Integrierte Schaltung nach Anspruch 5, dadurch gekennzeichnet, dass die zweiten Schalter (44, 45) zum Schließen während den Funktionsperioden mit Kontakt der integrierten Schaltung gesteuert sind.

7. Integrierte Schaltung nach einem der Ansprüche 5 oder 6, dadurch gekennzeichnet, dass die zweiten Schalter (44,45) mittels eines Signals (/CTL) zum Darstellen des Funktionsmodus der integrierten Schaltung gesteuert sind.

8. Integrierte Schaltung nach einem der vorangehenden Ansprüche, dadurch gekennzeichnet, dass die Ladungspumpen (10) mehrere Kapazitäten ($C_I$-$C_N$) in Reihe enthalten, getrennt durch Dioden ($T_i$-$T_N$) derart, dass eine Verbindung mit dem einen oder anderen der Takteingänge ($E_1$, $E_2$) der Ladungspumpen besteht.

9. Portabler Träger mit einer integrierten Schaltung gemäß einem der vorangehenden Ansprüche.

10. Chipcard mit einer integrierten Schaltung gemäß einem der Ansprüche 1 bis 8.

## Claims

1. Integrated circuit (30) comprising a charge pump (10) with two clock inputs ($E_1$, $E_2$) and operating without contact by means of at least one coil (L) forming with a tuning capacity ($C_A$) a tuned resonant circuit (36),
   characterised in that, during the periods of operation of the integrated circuit:

   - the clock inputs ($E_1$, $E_2$) of the charge pump (10) are connected permanently to the terminals of the coil (L), and
   - the capacity ($C_E$) of the charge pump, looked at from its clock inputs ($E_1$, $E_2$) constitutes a permanent component of the tuning capacity ($C_A$) of the tuned resonant circuit (36).

2. Integrated circuit (30) according to Claim 1, in which the clock inputs ($E_1$, $E_2$) of the charge pump (10) are connected directly to the terminals of the coil (L)

3. Integrated circuit (40) having two modes of operation, with or without contact, comprising:

   - a charge pump (10) having two clock inputs ($E_1$, $E_2$),
   - at least one coil (L) forming with a tuning capacity ($C_A$) a tuned resonant circuit (36) for receiving an alternating supply voltage (Va) in the non-contact mode of operation, and
   - contact studs (p1,p2, pi) for receiving a continuous supply voltage (Vcc2) in the contact mode of operation,

   characterised in that:

   - the clock inputs ($E_1$, $E_2$) of the charge pump (10) are connected to the terminals of the coil (L) through the intermediary of first breakers (41, 42),
   - the said first breakers (41, 42) are controlled (CTL) to close permanently during the periods of non-contact operation of the integrated circuit, in such a way that, during the periods of non-contact operation of the integrated circuit, the clock inputs ($E_1$, $E_2$) of the charge pump(10) are permanently connected to the terminals of the coil (L),
   - the capacity ($C_E$) of the charge pump, looked at from its clock inputs ($E_1$, $E_2$), constitutes a permanent component of the tuning capacity ($C_A$) of the tuned resonant circuit (36).

4. Integrated circuit according to Claim 4, in which the said first breakers (41, 42) are controlled by a signal (CTL) representative of the mode of operation of the integrated circuit.

5. Integrated circuit according to one of Claims 3 and 4, in which the clock inputs ($E_1$, $E_2$) of the charge pump (10) are in addition connected to the outputs ($H_1$, $H_2$) of an oscillator (43) through the intermediary of second breakers (44, 45).

6. Integrated circuit according to Claim 5, in which the said second breakers (44, 45) are controlled to be closed during the periods of contact operation of the integrated circuit.

7. Integrated circuit according to one of Claims 5 and 6, in which the said second breakers (44, 45) are controlled through the intermediary of a signal (/ CTL) representative of the mode of operation of the integrated circuit.

8. Integrated circuit according to one of the foregoing claims, in which the charge pump (10) comprises a plurality of capacities ($C_1$-$C_N$) in cascade separated by diodes ($T_1$ - $T_N$)and connected to one or the other of the clock inputs ($E_1$, $E_2$) of the charge pump.

9. Portable carrier incorporating an integrated circuit according to one of the foregoing claims.

10. Smart card incorporating an integrated circuit according to one of the Claims 1 to 8.

FIG.1

FIG.2

FIG.3

FIG.4

EP 0 948 775 B1

**FIG.5**

**FIG.6**

**FIG.7**